# EUROPÄISCHE PATENTSCHRIFT

(11) **EP 0 330 053 B1**
(45) Veröffentlichungstag und Bekanntmachung des Hinweises auf die Patenterteilung: **03.08.1994**
(21) Anmeldenummer: 89102516.5
(22) Anmeldetag: 14.02.1989
(51) Int. Cl.: B23K 20/00

(54) **Vorrichtung und Verfahren zur gesteuerten Zuführung eines Bonddrahtes zum wedge oder zur Kapillare eines Bondkopfes**
Device and method for the controlled supply of a bonding wire to the wedge or to the capillary of a bonding head
Dispositif et méthode pour commander l'alimentation d'un fil de jonction au coin ou au capillaire d'une tête de jonction

(30) Priorität: 23.02.1988 DE 3805584; 26.07.1988 DE 3825373
(43) Veröffentlichungstag der Anmeldung: 30.08.1989
(73) Patentinhaber: F & K Delvotec Bondtechnik GmbH, D-82041 Oberhaching (DE)
(72) Erfinder: Farassat, Farhad, D-8000 München 71 (DE)
(74) Vertreter: Popp, Eugen, Dr.

(56) Entgegenhaltungen:
- US-A- 3 116 889
- PATENT ABSTRACTS OF JAPAN vol. 6, no. 6 (E-89)(884) 14 Januar 1982,& JP-A-56 129333 (HITACHI SEISAKUSHO K.K.) 09 Oktober 1981,
- SCHWEIZERISCHE TECHNISCHE ZEITSCHRIFT no. 3, 20 Januar 1972, Wabern (CH) Seiten35 - 36; Walter Wulch: "Thermo-Kompressionsschweissen von Anschlussdrähten inder Mikrotechnik"

## Beschreibung

Die Erfindung betrifft eine Vorrichtung sowie ein Verfahren zur gesteuerten Zuführung eines Bonddrahtes, insbesondere Goldbonddrahtes, zum "wedge" (Keilstück) oder zur Kapillare eines auf- und abbewegbaren Bondkopfes nach dem Oberbegriff der Ansprüche 1 und 10.

Unter Bonden versteht man in der Mikroelektronik im allgemeinen das Verbinden von Bauelementen untereinander durch Kleben oder Schweißen im Unterschied zum üblichen Löten, wo die Verbindung mittels eines Lotes (meist Zinn-Blei-Legierung) hergestellt wird. Dabei unterscheidet man zwischen Chip-(Die)-Bondverfahren zum Befestigen eines Bauelementes auf einem Trägersubstrat und Draht-Bondverfahren zum Verbinden der Bauelementanschlüsse mit dem Trägersubstrat mittels feiner Drähte. Dabei unterscheidet man das sogenannte Thermokompressionsbonden, auch als nail-head-ball-Bonden bekannt, und das sogenannte Ultraschall-wedge-Bonden. Eine Kombination aus Thermokompressions- und Ultraschall-wedge-Bonden ist das sogenannte Thermosonic-Bonden. Dieses Verfahren erfreut sich immer größerer Beliebtheit. Hier wird meist Golddraht verwendet, der ähnlich wie beim ball-Bonden zu einer Kugel abgeschmolzen wird. Das Verschweißen erfolgt bei mäßiger Hitze mit Hilfe von Ultraschall. Dieses Verfahren ist relativ gut beherrschbar und auch automatisierbar. Zum erwähnten Stand der Technik sei auf die US-A-34 59 355, 33 57 090 und 31 28 649 oder DE-A-33 35 840 und DE-C-35 37 551 verwiesen, die einen gewissen Überblick über die genannte Bondtechnik vermitteln.

Bei allen Draht-Bondverfahren wird der Bonddraht mittels Klemmen oder Zangen entweder zur Bondstelle (pad) nachgezogen oder nach dem Bonden von dieser zum Abreißen des Bonddrahtes wieder weggezogen. Während einer loop-Bildung sind die erwähnten Klemmen und Zangen offen mit der Folge, daß der Bonddraht relativ widerstandslos nachgezogen werden kann. Dies wiederum hat jedoch zur Folge, daß die Länge des nachgezogenen Drahtes und damit die loop-Größe abhängig ist von zufällig herrschenden Widerständen an der Drahtspule und in der Drahtführung. Bei größeren loops hat sich gezeigt, daß die zur loop-Bildung erforderliche Drahtlänge sehr häufig zu klein ist. Bei kleineren loops tritt des öfteren das Gegenteil ein.

Beim ball-Bonden tritt zusätzlich das Problem des sogenannten "Golfschlages" auf. Der im Abstand von einigen µ von der Kapillaröffnung ausgebildete "ball" wird beim Absenken der Kapillare in Richtung zum "pad" bzw. zur Bondstelle hin gestoßen mit der Folge, daß der "ball" unter praktisch widerstandslosem Nachziehen des Bonddrahtes auf der Bondstelle aufprallt und gegebenenfalls sogar wieder zurückspringt, bevor die Kapillare vollständig abgesenkt ist und den "ball" mit der Bondstelle verschweißt. Dabei verliert der "ball" sehr häufig seine Zentrierung gegenüber der Kapillare bzw. der der Bondstelle zugekehrten etwa konisch erweiterten Kapillaröffnung mit der Folge einer fehlerhaften Bondverbindung. Beim ball-Bonden gilt es also, die Drahtspannung nicht nur während der loop-Bildung, sondern auch beim "touch-down" des "balls" konstant zu halten, um eine präzise Bondverbindung zu erhalten.

Des weiteren ist aus der S.T.Z. Schweizerische Technische Zeitschrift, Nr. 3, 20. Januar 1992, Vol. 69, Wabern (CH) Walter Wulch, "Thermo-Kompressionsschweißen von Anschlußdrähten in der Mikrotechnik", Seiten 35 und 36 eine Vorrichtung und ein Verfahren zur gesteuerten Zuführung eines Bonddrahtes, insbesondere Goldbonddrahtes, zum "wedge" (Keilstück) oder zur Kapillare eines auf- und abbewegbaren Bondkopfes bekannt. Die Zuführung erfolgt dabei über einen dem "wedge" oder der Kapillare vorgeordneten Bonddraht-Führungskanal. Nach diesem Verfahren wird der Bonddraht von einer Vorratsspule in einem Strom reinen Stickstoffes direkt bis zu der Elektrodenspitze des Bondkopfes geführt. Hierdurch soll die Oberfläche des Bonddrahtes während seiner Zuführung von der Vorratsspule hin zu der Elektrodenspitze gegen Oxidation geschützt werden. Der Stickstoff wird dabei offenbar über einen Fluidanschluß, der in den Bonddraht-Führungskanal einmündet, eingeleitet. Weitere Maßnahmen in vorrichtungs- bzw. verfahrenstechnischer Hinsicht zur Zuführung des Bonddrahtes von der Vorratsspule hin zu der Elektrodenspitze sind nicht beschrieben.

Schließlich sei an dieser Stelle noch auf die CH-A-592 365 hingewiesen, aus der eine Steuerung der Bonddrahtspannung mittels einer äußeren Gasströmung hervorgeht. Die Gasströmung wirkt dort jedoch nicht unmittelbar auf den Bonddraht im Sinne eines fluidischen Vorschubs oder einer fluidischen "Abbremsung", sondern nur mittelbar über eine fluidisch drehbewegte Rohrschleife ein, durch die hindurch der Bonddraht zur Bondstelle geführt ist.

Der vorliegenden Erfindung liegt daher die Aufgabe zugrunde, die Zuführung des Bonddrahtes so zu steigern, daß während des gesamten Betriebs des Bonders eine vorgegebene loop-Größe eingehalten und beim ball-Bonden zusätzlich der sogenannte "Golfschlag" vermieden wird, wobei die mechanische Einwirkung auf den Bonddraht ein Minimum sein soll.

Dieser Aufgabe wird durch die kennzeichnenden Merkmale der Ansprüche 1 und 10 gelöst, und zwar sowohl vorrichtungs- als auch verfahrenstechnisch.

Auf diese Weise wird der Bonddraht durch die Fluideinwirkung in Abhängigkeit des jeweiligen Bedarfs ausschließlich mittels Fluideinwirkung von der Vorratsspule zu der Elektrodenspitze hingeführt, d.h. geschoben oder zurückgehalten bzw. gebremst. Die Zuführung des Bonddrahtes kann daher ohne jegliche mechanische Einwirkung auf den Bonddraht selbst erfolgen. Zudem kann die Zuführung des Bonddrahtes über die Fluideinwirkung in Folge der Beaufschlagung des Bonddrahtes mit unter Überdruck bzw. Unterdruck stehendem Fluid genau dosiert bzw. eingestellt werden. Dabei läßt sich eine im wesentlichen konstante Bonddrahtspannung erhalten, wodurch eine vorgegebene Drahtlänge für die Bildung eines loops relativ genau eingehalten und beim ball-Bonden zusätzlich der sogenannte "Golfschlag" vermieden wird. Dementsprechend kann der bonddraht bei kleineren loops und bei einem sogenannten "touch-down" des "balls" fluidisch gebremst, bei größeren loops fluidisch nachgeschoben werden. Neben einer zusätzlichen Verbesserung hinsichtlich Präzision und Arbeitsgeschwindigkeit führt dies letztendlich zu einer variablen, beliebig änderbaren und ausgesprochen schonenden Zuführung des Bonddrahtes.

Eine zusätzliche Verbesserung hinsichtlich Präzision und Arbeitsgeschwindigkeit kann durch eine dem Bonddraht-Führungskanal zugeordnete, insbesondere vor- oder am kapillarenseitigen Ende derselben angeordnete Bonddraht-Rutschklemme erhalten werden, die entweder permanent oder nur beim Absenken des Bondkopfes zum "touch-down" wirksam bzw. geschlossen ist.

Vorzugsweise handelt es sich bei der Bonddraht-Rutschklemme um eine Klammer, deren wirksame Klemmflächen filz- oder dgl. -beschichtet sind. Auf diese Weise läßt sich der Bonddraht unter Aufrechterhaltung einer vorgegebenen Spannung durch die Klammer hindurchziehen. Die erfindungsgemäß vorgesehene Bonddraht-Rutschklemme hat neben der Aufrechterhaltung einer vorgegebenen Bonddraht-Spannung und damit Bonddraht-Steifigkeit zusätzlich den großen Vorteil, daß aus dem Bonddraht ein diesem immanenter Drall "herausgenommen bzw. -gezogen" wird mit der Folge, daß sich bei loop-Bildung der Bonddraht nicht mehr unkontrolliert verwerfen kann. Dementsprechend erlaubt die erfindungsgemäß vorgesehene Rutschklemme die Ausbildung exakter loops. Vorzugsweise ist die Rutschklemme steuerbar, d. h. öffen- und schließbar in Abhängigkeit von der Auf- bzw. Abbewegung des Bondkopfes und entsprechender Einwirkung auf den Bonddraht.

Die erfindungsgemäß vorgeschlagene Anordnung der Rutschklemme am kapillarenseitigen Ende des Bonddraht-Führungskanals ist aufgrund der Nähe zum Bondkopf besonders wirkungsvoll. Die Ausbildung des Über- oder Unterdrucks im Führungskanal wird durch die Anordnung der Rutschklemme am kapillarenseitigen Ende ds Führungskanals nicht mehr beeinflußt.

Vorzugsweise in Kombination mit der beschriebenen Rutschklemme, aber auch unabhängig davon, ist dem Bonddraht-Führungskanal eine ortsfeste Bonddraht-Klammer nachgeordnet, die in Abhängigkeit von der Höhe des Bondkopfes bzw. vom Abstand der Kapillarenspitze von der Bondstelle schließ- bzw. öffenbar ist unter Rückzug und entsprechender Entfernung eines aus der Kapillarenspitze nach unten heraushängenden Bonddrahtabschnitts unmittelbar vor dem "touch-down".

Dadurch läßt sich die optimale Drahtlänge für die loop-Bildung vorbestimmen bzw. vorprogrammieren. Überflüssige Drahtlänge wird im Bereich der Kapillarenspitze entfernt, soweit sich dies durch fluidische Abbremsung des Bonddrahts sowie durch Zurückhalten des Bonddrahts mittels der oben beschriebenen Rutschklemme nicht erreichen läßt. Durch diesen Effekt lassen sich nach jeder loop-Bildung Fehlkontakte vermeiden. Vor allem läßt sich erreichen, daß auch beim zweiten Bond nach loop-Bildung der Bonddraht an der Bondstelle über den eigentlichen "Kontaktpunkt" hinaus nicht aufliegt.

Unter gleichzeitiger Verwendung der oben beschriebenen Rutschklemme lassen sich also steife loops optimaler Länge unter gleichzeitiger Vermeidung von Fehlkontakten herstellen.

Unter Verwendung der beschriebenen Konstruktionsmaßnahmen erfolgt das Bonden vorzugsweise entsprechend den in den Ansprüchen 10 bis 12 bzw. 13 und/oder 14 beschriebenen Verfahren.

Nachstehend werden Ausführungsbeispiele des erfindungsgemäßen Systems anhand der beigefügten Zeichnung näher beschrieben. Es zeigen:
- Fig. 1: eine Einfachausführung einer erfindungsgemäß ausgebildeten Vorrichtung in schematischer Seitenansicht, teilweise im Schnitt;
- Fig. 2: eine gegenüber der Ausführungsform gemäß Fig. 1 konstruktiv ergänzte Vorrictung, ebenfalls in schematischer Seitenansicht und teilweise im Schnitt;
- Fig. 3: die Ausbildung eines loops und die Stellung der Kapillare unmittelbar vor dem zweiten "touch-down";
- Fig. 4: eine fehlerhafte loop-Ausbildung und dementsprechend fehlerhafte Bond-Verbindung, wie sie unter Verwendung herkömmlicher Bonder häufig vorkommen; und
- Fig. 5: die schematische Darstellung eines optimalen loops und einer optimalen Bondverbindung unter Anwendung der erfindungsgemäßen Vorrichtung bzw. des erfindungsgemäßen Verfahrens.

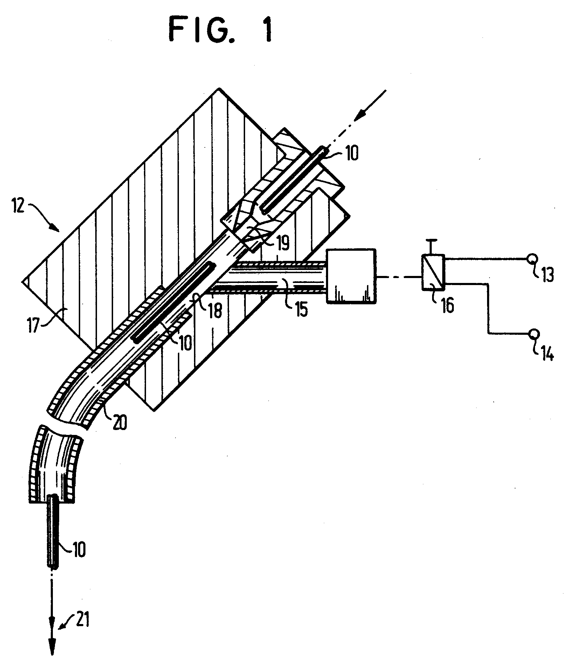

Gemäß Fig. 1 dient zur gesteuerten Zuführung eines Bonddrahtes 10 zu einem in Fig. 1 nichtdargestellten "wedge" (Keilstück) oder zu einer in Fig. 1 ebenfalls nichtdargestellten Kapillare eines Bondkopfes eine dem "wedge" oder der Bondkapillare vorgeordnete Bonddrahtführung 12, in die ein wahlweise mit einer Druckgas-, nämlich Druckluftquelle 13 oder Unterdruckquelle 14 verbindbarer Anschluß 15 mündet. Dem zuletzt erwähnten Anschluß 15 ist ein Umschaltventil 16 zugeordnet, mittels dem der Anschluß 15 entweder mit der Druckluftquelle 13 oder Unterdruckquelle 14 verbindbar ist. Das Umschaltventil 16 ist mit der Ablaufsteuerung des im einzelnen nichtdargestellten Bonders bzw. dessen Bondkopfes gekoppelt.

Die Bonddrahtführung 12 weist einen Montageblock 17 mit einer Durchgangsbohrung 18 auf, an deren spulenseitigem Ende eine Drahtführungsdüse 19 fixiert ist, während am wedge- oder kapillarseitigen Ende der Durchgangsbohrung 18 ein Draht-Leitröhrchen 20 eingesetzt ist. Der mit der Druckluft- oder Unterdruckquelle verbindbare Anschluß 15 liegt unmittelbar hinter der Drahtführungsdüse 19. Er mündet in die Durchgangsbohrung 18 zwischen Drahtführungsdüse 19 und Draht-Leitröhrchen 20. Die Drahtführungsdüse 19 ist ähnlich wie eine Bondkapillare ausgebildet. Sie weist an ihrem wedge- bzw. kapillarseitigen Ende eine düsenartige Verengung auf, durch die der von der nichtdargestellten Drahtspule kommende Bonddraht 10 eingefädelt wird. Die Einfädelung und ggfs. Zuführung des Bonddrahtes 10 zum wedge bzw. zur Bondkapillare erfolgt mit Druckluftunterstützung, indem durch den Anschluß 15 bei entsprechender Schaltung des Ventils 16 Druckluft in die Durchgangsbohrung 18 eingeblasen wird. Der Anschluß 15 mündet in die Durchgangsbohrung 18 in einem spitzen Winkel zur Längsachse der Drahtführungsdüse 19, so daß bei Einleitung von Druckluft in die Durchgangsbohrung 18 der Bonddraht 10 durch die Bonddrahtführung 12 hindurch fluidisch geschoben wird. Es bildet sich innerhalb der Durchgangsbohrung 18 und des Draht-Leitröhrchens 20 um den Bonddraht 10 eine koaxiale Strömung in Richtung zum wedge bzw. zur Bondkapillare aus. Diese koaxiale Luftströmung bewirkt ein Nachschieben des Bonddrahtes 10, und zwar in Abhängigkeit von der Intensität der eingeblasenen Luft.

Bei Verwendung eines Golddrahtes mit einem Durchmesser von etwa 25 µ bis 100 µ beträgt der minimale Innendurchmesser der ausgangsseitigen Verengung der Drahtführungsdüse 19 etwa 100 µ bis 130 µ. Die Durchgangsbohrung 18 sowie das Draht-Leitröhrchen weisen dagegen einen Innendurchmesser von etwa 1,5 mm bis 2,2 mm auf. Die sich daraus ergebenden Durchmesser-Verhältnisse gelten ganz generell.

Bei Verbindung des Anschlusses 15 an die Unterdruckquelle 14 wird der Bonddraht 10 regelrecht gebremst unter Aufrechterhaltung einer im wesentlichen konstanten Drahtspannung. Es wird dadurch verhindert, daß insbesondere bei der loop-Bildung zuviel Bonddraht nachgezogen wird mit der Folge eines unverhältnismäßig großen loops. Bei Ausbildung größerer loops ist es dagegen von Vorteil, wenn Druckluft durch den Anschluß 15 eingeblasen wird. Der Bonddraht 10 wird dadurch regelrecht nachgeschoben, so daß ausreichend Draht für die loop-Bildung vorhanden ist. Die beschriebene Vorrichtung eignet sich demnach auch ganz besonders gut, wenn hintereinander loops unterschiedlicher Größe gebildet werden müssen. Die entsprechende Steuerung der fluidischen Einwirkung auf den Bonddraht erfolgt über das Ventil 16 in Abhängigkeit von den Bondkopf-Steuerbefehlen.

Beim ball-Bonden wird durch die fluidische Konstanthaltung der Drahtspannung ein sanftes Absenken des "balls" samt Kapillare auf die Bondstelle unter Aufrechterhaltung der ball-Zentrierung erreicht, d. h. der eingangs erläuterte "Golfschlag" vermieden.

Vorzugsweise weist die koaxiale Strömung eine Drallkomponente um den Bonddraht auf, wodurch dieser innerhalb der Durchgangsbohrung 18 sowie des Leitröhrchens 20 regelrecht zentriert wird. Bei der dargestellten Ausführungsform ist das Leitröhrchen 20 vertikal nach unten zum "wedge" bzw. zur Bondkapillare hin gebogen.

Die dargestellte Einrichtung sowie das beschriebene Verfahren kann bei herkömmlichen Bondgeräten nachträglich montiert und eingesetzt werden. Als besonders vorteilhaft haben sich die beschriebene Vorrichtung sowie das beschriebene Verfahren beim Golddrahtbonden herausgestellt.

Die fluidische Einwirkung auf den Bonddraht kann vorzugsweise variierbar gestaltet sein, z. B. hinsichtlich Druck und Luftdurchsatz unter entsprechender Veränderung der Drahtspannung in Anpassung an unterschiedliche Verfahrensstufen des Bondkopfes.

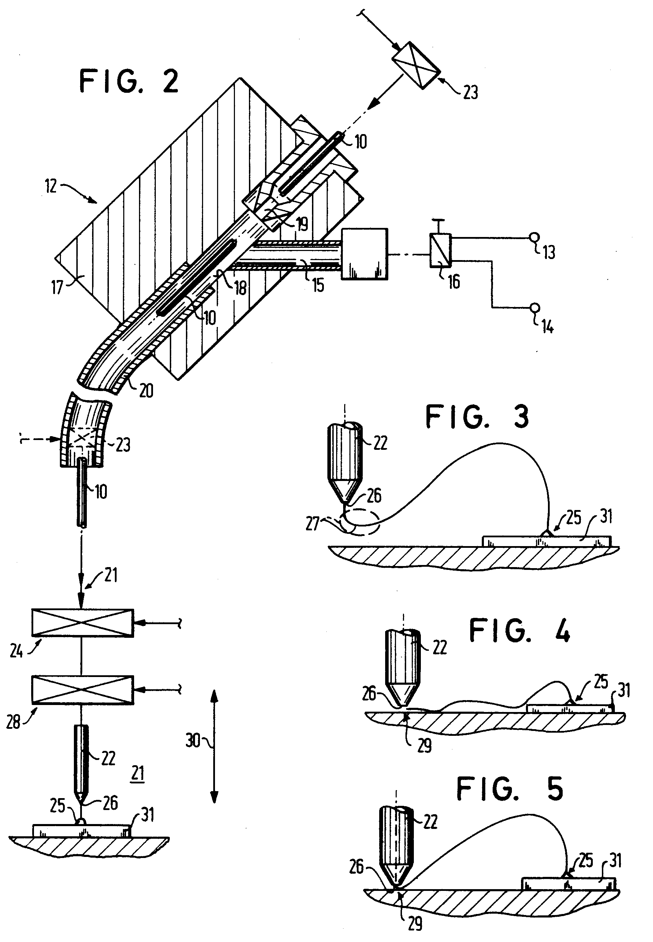

Die Konstruktion nach Fig. 2 unterscheidet sich von derjenigen nach Fig. 1 durch die Anordnung einer Bonddraht-Rutschklemme 23, die dem Bonddraht-Führungskanal 12, 18, 19, 20 entweder vorgeordnet (wie voll ausgezeichnet in Fig. 2 dargestellt) oder am kapillarenseitigen Ende desselben, nämlich am kapillarenseitigen Ende des Bonddraht-Leitröhrchens 20 (wie gestrichelt in Fig. 2 angedeutet) angeordnet ist, wobei die Bonddraht-Rutschklemme 23 entweder permanent oder nur beim Absenken des Bondkopfes 21 zum sogenannten "touch-down" wirksam bzw. geschlossen ist. Die Bonddraht-Rutschklemme 23 ist vorzugsweise eine Klammer, deren wirksame Klemmflächen mit einem Filzbelag oder dgl. versehen sind, so daß der Bonddraht 10 auch bei geschlossener Klammer 23 durch diese noch hindurchziehbar ist, jedoch unter Aufrechterhaltung einer vorbestimmten Drahtspannung und -steifigkeit sowie unter Herausnahme eines etwaigen Dralls im Draht. Dadurch werden im Vergleich zum Stand der Technik wesentlich steifere loops erhalten, die darüber hinaus frei von drallbedingten Verwerfungen sind. Bei den unter Verwendung der beschriebenen Rutschklemme 23 hergestellten loops besteht nicht die Gefahr, daß diese unter Ausbildung von Fehlkontakten entsprechend Fig. 4 in sich zusammenfallen. Vielmehr wird eine loop-Konfiguration entsprechend Fig. 5 erhalten. Darüber hinaus ist bei der Ausführungsform nach Fig. 2 dem Bonddraht-Führungskanal 12, 18, 19, 20, und zwar konkret dem Leitröhrchen 20, eine ortsfeste, d. h. nicht mit dem Bondkopf 21 mitbewegbare Bonddraht-Klammer 24 nachgeordnet, die in Abhängigkeit von der Höhe des Bondkopfes 21 bzw. vom Abstand der Kapillarenspitze 26 von der Bondstelle 25 schließ- bzw. öffenbar ist unter Rückzug und entsprechender Entfernung eines aus der Kapillarenspitze 26 nach unten heraushängenden Bonddrahtabschnitts 27 (siehe Fig. 3) unmittelbar vor dem "touch-down".

Der Kapillare 22 ist eine weitere Bonddraht-Klammer 28 zugeordnet, wobei diese mit dem Bondkopf 21 auf- und abbewegbar ist.

Die Zuführung des Bonddrahtes 10 zur Kapillare 22 erfolgt unter Verwendung der Klammern 24, 28 sowie der Rutschklemme 23 wie folgt:

Zunächst wird der Bondkopf 21 von einer angehobenen Start- bzw. Ausgangsposition unter Mitnahme des Bonddrahtes 10 mittels der am Bondkopf 21 angeordneten Klammer 28 abgesenkt, wobei die Mitnahme des Bonddrahtes 10 entgegen der Wirkung einer den Bonddraht 10 unter geringer Zugspannung haltenden koaxialen Fluidströmung im Bonddraht-Führungskanal und entgegen der Wirkung der Rutschklemme 23 bei vorheriger oder gleichzeitiger Ausbildung eines "balls" am freien Ende des Bondrahtes 10 erfolgt. Der Bonddraht 10 wird also bei dieser Absenkbewegung des Bondkopfes 21 bzw. der diesem zugeordneten Bondkapillare 22 sowohl fluidisch im Bonddraht-Führungskanal (Anschluß der Unterdruckquelle 14) als auch mechanisch durch die Bonddraht-Rutschklemme 23 unter Spannung gehalten.

Kurz vor dem "touch-down" wird die mit der Kapillare 22 mitbewegte Bonddraht-Klammer 28 geöffnet, so daß der am freien Ende des Bonddrahtes 10 ausgebildete "ball" in Anlage an die konisch oder kugelpfannenartig ausgebildete Kapillarenspitze 26 unter Vermeidung des beschriebenen "Golfschlages" gelangt. Dann erfolgt der "touch-down" unter gleichzeitiger Ultraschallerregung der Kapillare 22 und Ausbildung eines ersten Bonds 25.

Nachdem der erste Bond 25 auf einem "pad 31" ausgebildet worden ist, wird der Bondkopf 21 samt Kapillare 22 wieder hochgefahren, und zwar bis zu einer vorgegebenen loop-Höhe, und zwar vorzugsweise unter Öffnung der Rutschklemme 23, sofern es sich um eine steuerbare Rutschklemme handelt, und gegebenenfalls unter Ab- oder Umschaltung der koaxialen Fluidströmung entsprechend der Größe des auszubildenden loops (siehe obige Ausführungen dazu). Anschließend erfolgt die Positionierung der zweiten Bondstelle gegenüber der Kapillare 22. Der Bondkopf 21 samt Kapillare 22 wird abgesenkt unter Mitnahme des Bonddrahtes 10, und zwar wieder entgegen der Wirkung der beschriebenen koaxialen Fluidströmung sowie gegebenenfalls erneut geschlossenen Rutschklemme 23 bis zum erneuten bzw. zweiten "touch-down" und Ausbildung eines zweiten Bonds 29 unter Einwirkung von Ultraschall. Vorzugsweise schließt kurz vor dem zweiten "touch-down" ausgehend von der loop-Höhe die oberhalb des Bondkopfes 21 ortsfest angeordnete Klammer 24 unter Fixierung des Bonddrahtes 10 bzw. entsprechendem Rückzug des Bonddrahtes 10 durch die nach unten bewegte Kapillare 22. Auf diese Weise wird ein aus der Kapillarenspitze 26 nach unten heraushängender Bonddrahtabschnitt 27 entsprechend Fig. 3 unmittelbar vor dem zweiten "touch-down" entfernt. Dadurch erhält man entsprechend Fig. 5 einen zweiten Bond 29, ohne daß der Bonddraht über den eigentlichen "Kontaktpunkt" hinaus auf dem Substrat aufliegt bzw. dieses berührt. Wird die überschüssige Bonddrahtlänge 27 nicht wie beschrieben entfernt, besteht die Gefahr, daß ein Zweiter Bond 29 entsprechend Fig. 4 entsteht, bei dem der Draht über eine unverhältnismäßig große Länge auf dem Substrat aufliegt. Die Klammer 24 schließt bei vorbestimmter bzw. vorprogrammierter Höhe des Bondkopfes 21 bzw. der Kapillare 22 abhängig von dem Material des Bonddrahtes 10 sowie der Größe des loops. Nach Ausbildung des Zweiten Bonds 29 wird die Klammer 24 wieder geöffnet. Des weiteren wird der Bondkopf 21 dann wieder hochgefahren, und zwar bis zur sogenannten tail-length-Höhe. In diesem Fall ist vorzugsweise auch die Rutschklemme 23 geöffnet, sofern es sich um eine steuerbare Rutschklemme handelt. Doch nach wie vor ist vorzugsweise die beschriebene Koaxialströmung wirksam, die den Bonddraht 10 zurückhält. Diese gilt insbesondere dann, wenn die Rutschklemme 23 am kapillarenseitigen Ende des Bonddraht-Leitröhrchens 20 angeordnet ist. Letztlich hängt die Schaltung der Koaxialströmung, d. h. Ein- und Abschaltung sowie Richtung von der Eigensteifigkeit, d. h. Material und Durchmesser des Bonddrahts 10, ab.

In tail-length-Höhe des Bondkopfes 21 wird die dem Bondkopf zugeordnete Klammer 28 wieder geschlossen. Dann fährt der Bondkopf 21 zurück zur Ausgangsposition unter Abreißen des Bonddrahtes 10. Ein erneuter Bondvorgang in der beschriebenen Weise kann beginnen.

Bei den Bonddraht-Klammern 24, 28 handelt es sich um herkömmliche Draht-Klemmeinrichtungen, so daß eine nähere Darstellung und Beschreibung derselben entbehrlich erscheint. Ähnlich verhält es sich bei der Ausbildung der Kapillare 22.

Die Rutschklemme 23 ist entsprechend einer herkömmlichen Drahtklammer ausgebildet, nur mit dem Unterschied, daß die Klemmflächen mit einem Filzbelag oder dgl. versehen sind derart, daß auch bei geschlossener Klemmeinrichtung der Bonddraht 10 noch hindurchgezogen werden kann. Vorzugsweise ist die Klemmkraft der Rutschklemme 23 einstellbar, insbesondere variierbar unter Anpassung an verschiedene Bonddrähte (Material und Durchmesser).

Auch die Vorrichtung gemäß Fig. 2 kann bei herkömmlichen Bondern nachträglich montiert bzw. eingesetzt werden.

## Patentansprüche

1. Vorrichtung zur gesteuerten Zuführung eines Bonddrahtes, insbesondere Goldbonddrahtes (10), zum "wedge" das ein Keilstück darstellt oder zur Kapillare (22) eines auf- und abbewegbaren (Doppelpfeil 30) Bondkopfes (21) über einen dem "wedge" oder der Kapillare (22) vorgeordneten Bonddraht-Führungskanal (12, 18, 19, 20), wobei in den Bonddraht-Führungskanal (12, 18, 19, 20) ein Fluidanschluß (15) einmündet,
**dadurch gekennzeichnet,**
daß der in den dem "wedge" oder der Kapillare (22) vorgeordneten Bonddraht-Führungskanal (12, 18, 19, 20) zur Zuführung des Bonddrahtes einmündende Fluidanschluß (15) wahlweise sowohl mit einer Druckgas-, insbesondere Druckluftquelle (13) als auch mit einer Unterdruckquelle (14) verbunden ist.

2. Vorrichtung nach Anspruch 1,
dadurch gekennzeichnet,
daß dem Fluidanschluß (15) ein mit der Bondkopfsteuerung gekoppeltes Umschaltventil (16) zugeordnet ist, mittels dem Fluidanschluß (15) entweder mit der Druckgas- bzw. Druckluftquelle (13) oder mit der Unterdruckquelle (14) verbunden ist.

3. Vorrichtung nach Anspruch 1 oder 2,
dadurch gekennzeichnet,
daß der Bonddraht-Führungskanal eine Drahtführungsdüse (19) aufweist, an die sich wedge- oder kapillarseitig ein Draht-Leitröhrchen (20) größeren Innendurchmessers anschließt, wobei der mit der Druckgas- bzw. Druckluftquelle (13) oder mit der Unterdruckquelle (14) verbundene Fluidanschluß (15) unmittelbar hinter der Drahtführungsdüse (19) liegt.

4. Vorrichtung nach Anspruch 3,
dadurch gekennzeichnet,
daß die Drahtführungsdüse (19) am spulenseitigen Ende einer in einem Montageblock (17) ausgebildeten Durchgangsbohrung (18) fixiert ist, während das Draht-Leitröhrchen (20) am wedge- oder kapillarseitigen Ende der Durchgangsbohrung (18) angeschlossen ist, und daß der mit der Druckgas- bzw. Druckluftquelle (13) oder mit der Unterdruckquelle (14) verbundene Fluidanschluß (15) zwischen Drahtführungsdüse (19) und Draht-Leitröhrchen (20) in die Durchgangsbohrung (18) mündet.

5. Vorrichtung nach einem der Ansprüche 1 bis 4,
dadurch gekennzeichnet,
daß der mit der Druckgas- bzw. Druckluftquelle (13) oder mit der Unterdruckquelle (14) verbundene Fluidanschluß (15) unter einem spitzen Winkel zur Drahtführungsdüse (19) in die Bonddrahtführung (12) mündet.

6. Vorrichtung nach einem der Ansprüche 3 bis 5,
dadurch gekennzeichnet,
daß der Innendurchmesser der ausgangsseitig angeordneten Verengung der Drahtführungsdüse (19) bei einem Drahtdurchmesser von kleiner als 100 µ etwa 100 bis 130 µ beträgt, während das der Drahtführungsdüse (19) folgende Draht-Leitröhrchen (20) einen Innendurchmesser von etwa 1,5 bis 2,2 mm aufweist.

7. Vorrichtung nach einem oder mehreren der Ansprüche 1 bis 6,
gekennzeichnet durch,
eine den Bonddraht-Führungskanal (12, 18, 19, 20) zugeordnete, insbesondere vor oder am kapillarenseitigen Ende desselben angeordnete Bonddraht-Rutschklemme (23), die entweder permanent oder nur beim Absenken des Bondkopfes (21) zum "touch-down" wirksam bzw. geschlossen ist.

8. Vorrichtung nach Anspruch 7,
dadurch gekennzeichnet,
daß die Bonddraht-Rutschklemme (23) durch eine Klammer gebildet ist, deren wirksame Klemmflächen filz- oder dgl. beschichtet sind.

9. Vorrichtung, nach einem der Ansprüche 1 bis 8,
dadurch gekennzeichnet,
daß dem Bonddraht-Führungskanal (12, 18, 19, 20) eine ortsfeste Bonddraht-Klammer (24) nachgeordnet ist, die nach Absenken des Bondkopfes (21) von einer vorgegebenen loop-Höhe auf eine vorprogrammierbare Zwischenhöhe schließbar ist unter Rückzug und entsprechender Entfernung eines aus der Kapillarenspitze (26) nach unten heraushängenden Bonddrahtabschnitts (27) unmittelbar vor dem nachfolgenden "touch-down".

10. Verfahren zur gesteuerten Zuführung eines Bonddrahtes, insbesondere Goldbonddrahtes (10), zum "wedge" (Keilstück) oder zur Kapillare (22) eines auf- und abbewegbaren (Doppelpfeil 30) Bondkopfes (21) über einen dem "wedge" oder der Kapillare (22) vorgeordneten Bonddraht-Führungskanal (12, 18, 19, 20), wobei in den Bonddraht-Führungskanal (12, 18, 19, 20) ein Fluidanschluß (15) einmündet, unter Verwendung einer Vorrichtung nach einem der Ansprüche 1 bis 9,
dadurch gekennzeichnet,
daß der Bonddraht (10) während des Bondvorganges, insbesondere bei der loop-Bildung, mittels einer über den Fluidanschluß (15) eingeführten, koaxialen Gas-, insbesondere Luftströmung, in Richtung zum "wedge" oder zur Kapillare (22) des Bondkopfes (21) geschoben oder auf den Bonddraht (10) ein Zug in Richtung vom "wedge" oder der Kapillare (22) des Bondkopfes (21) weg unter Aufrechterhaltung einer etwa konstanten Drahtspannung ausgeübt wird.

11. Verfahren nach Anspruch 10,
dadurch gekennzeichnet,
daß die Richtung der koaxialen Gas-, insbesondere Luftströmung, während des Bondvorganges umkehrbar sowie die Intensität (Druck und/oder Durchsatz) der Gas-, insbesondere Luftströmung, variierbar ist.

12. Verfahren nach Anspruch 10 oder 11,
dadurch gekennzeichnet,
daß die koaxiale Gas- bzw. Luftströmung eine Drallkomponente um den Bonddraht (10) herum aufweist.

13. Verfahren nach einem der Ansprüche 10 bis 12,
mit folgenden Verfahrensschritten:
a) Absenken des Bondkopfes (21) von einer Start- bzw. Ausgangsposition unter Mitnahme des Bonddrahtes (10) mittels einer am Bondkopf (21) angeordneten und mit diesem mitbewegten Klemmeinrichtung (Bonddraht-Klammer 28), wobei die Mitnahme des Bonddrahtes (10) entgegen der Wirkung einer diesen unter geringer Zugspannung haltenden koaxialen Fluidströmung und/oder Bonddraht-Rutschklemme (23) bei vorheriger oder gleichzeitiger Ausbildung eines "balls" am freien Ende des Bonddrahtes (10) erfolgt;
b) "touch-down" unter Ultraschallerregung der Kapillare (22) und Öffnung der Bonddraht-Klammer (28) kurz vor dem "touch-down" sowie Ausbildung eines ersten Bonds (25);
c) Anheben des Bondkopfes (21) bis zu einer vorgegebenen loop-Höhe, vorzugsweise unter Öffnung der Bonddraht-Rutschklemme (23) und gegebenenfalls unter Ab- oder Umschaltung der koaxialen Fluidströmung;
d) Positionieren einer zweiten Bondstelle (29) gegenüber der Kapillare (22), Absenken des Bondkopfes (21) unter Mitnahme des Bonddrahtes (10) entgegen der Wirkung der gegebenenfalls wieder aktivierten koaxialen Fluidströmung und der gegebenenfalls erneut geschlossenen Bonddraht-Rutschklemme (23) bis zu einem zweiten "touch-down" sowie Ausbildung eines zweiten Bonds (29) unter Einwirkung von Ultraschall; und
e) Anheben des Bondkopfes (21) bis zu einer sog. "tail-length"-Höhe bei geöffneter Bonddraht-Klammer (28), vorzugsweise bei auch geöffneter Bonddraht-Rutschklemme (23), doch vorzugsweise bei nach wie vor wirksamer Koaxialströmung, abermaligem Schließen der Bonddraht-Klammer (28) und weiterem Anheben des Bondkopfes (21) unter Abreißen des Bonddrahtes (10) bis in die Ausgangsposition zurück.

14. Verfahren nach Anspruch 13,
dadurch gekennzeichnet,
daß kurz vor dem jeweils zweiten "touch-down" ausgehend von der loop-Höhe eine oberhalb des Bondkopfes (21) ortsfest angeordnete Bonddraht-Klammer (24) unter Fixierung des Bonddrahtes (10) bzw. entsprechendem Rückzug des Bonddrahtes (10) durch die nach unten bewegte Kapillare (22) geschlossen wird, vorzugsweise bei vorprogrammierter Zwischenhöhe des Bondkopfes (21) bzw. der Kapillare (22), um nach Ausbildung des jeweils zweiten Bonds (29) wieder geöffnet zu werden.

## Claims

1. A device for the controlled conveyance of a bond wire, in particular gold bond wire (10), to the "wedge" that represents a wedge-formed part or to the capillary (22) of a bond head (21), which can move up and down (double arrow 30), by way of a bond wire guide duct (12, 18, 19, 20) disposed in advance of the "wedge" or the capillary (22), wherein a fluid connection (15) issues into the bond wire guide duct (12, 18, 19, 20), characterised in that the fluid connection (15), issuing into the bond wire guide duct (12, 18, 19, 20) disposed in advance of the "wedge" or the capillary (22) for the purpose of conveying the bond wire, is alternatively connected to a compressed gas source, in particular a compressed air source (13), as well as to a negative pressure source (14).

2. A device according to claim 1, characterised in that a reversing valve (16), coupled to the bond head control, is allocated to the fluid connection (15) and is connected by means of the fluid connection (15) either to the compressed gas or compressed air source (13) or to the negative pressure source (14).

3. A device according to claim 1 or 2, characterised in that the bond wire guide duct comprises a wire guide nozzle (19) at which, on the "wedge" or capillary end, a wire guide tube (20) of a larger inner diameter connects, wherein the fluid connection (15), connected to the compressed gas or compressed air source (13) or to the negative pressure source (14), lies immediately behind the wire guide nozzle (19).

4. A device according to claim 3, characterised in that the wire guide nozzle (19) is fixed at the coil end of a through bore (18) formed in an assembly stand (17), while the wire guide tube (20) is connected at the "wedge" or capillary end of the through bore (18), and that the fluid connection (15), connected to the compressed gas or compressed air source (13) or to the negative pressure source (14), issues into the through bore (18) between the wire guide nozzle (19) and the wire guide tube (20).

5. A device according to one of claims 1 to 4, characterised in that the fluid connection (15), connected to the compressed gas or compressed air source (13) or to the negative pressure source (14), issues into the bond wire guide (12) at an acute angle to the wire guide nozzle (19).

6. A device according to one of claims 3 to 5, characterised in that the inner diameter of the constriction of the wire guide nozzle (19), disposed at the outlet end, amounts to approximately 100 to 130 µ with a wire diameter of less that 100 µ, while the wire guide tube (20) following the wire guide nozzle (19) comprises an inner diameter of approximately 1.5 to 2.22 mm.

7. A device according to one or several of claims 1 to 6, characterised in that a bond wire slip clamp (23) allocated to the bond wire guide duct (12, 18, 19, 20), in particular disposed in advance of or at the capillary end thereof, which clamp is closed or effective either permanently or only when the bond head (21) is lowered to "touch-down".

8. A device according to claim 7, characterised in that the bond wire slip clamp (23) is formed by a clamp, the effective clamping surfaces of which are coated with felt or the like.

9. A device according to one of claims 1 to 8, characterised in that a fixed bond wire clamp (24) is disposed after the bond wire guide duct (12, 18, 19, 20), which bond wire clamp, after the lowering of the bond head (21) from a preset loop level to a preprogrammable intermediate level, is closable while returning and correspondingly removing a portion of bond wire (27) hanging downwards from the point of the capillary (26) immediately prior to the subsequent "touch-down".

10. A process for the controlled conveyance of a bond wire, in particular gold bond wire (10), to the "wedge" (wedge-formed part) or to the capillary (22) of a bond head (21), which can move up and down (double arrow 30), by way of a bond wire guide duct (12, 18, 19, 20) disposed in advance of the "wedge" or capillary (22), wherein a fluid connection (15) issues into the bond wire guide duct (12, 18, 19, 20) using a device according to one of claims 1 to 9, characterised in that during the bond process, in particular during the loop formation, the bond wire (10) is pushed, by means of a coaxial flow of gas, in particular air, in the direction towards the "wedge" or the capillary (22) of the bond head (21) or a pull is exerted on the bond wire (10) in the direction away from the "wedge" or the capillary (22) of the bond head (21) while maintaining a wire tension that is more or less constant.

11. A process according to claim 10, characterised in that the direction of the coaxial flow of gas, in particular air, during the bond process is reversible and the intensity (pressure and/or throughput) of the gas, in particular the air, is variable.

12. A process according to claim 10 or 11, characterised in that the coaxial flow of gas or air comprises a rotational component around the bond wire (10).

13. A process according to one of claims 10 to 12, having the following process stages:
a) lowering the bond head (21) from a start or initial position while pulling along the bond wire (10) by means of a clamping device (bond wire clamp 28) disposed at the bond head (21) and moved as one therewith, wherein the bond wire (10) is pulled along against the effect of a coaxial flow of fluid, keeping the wire under this lower tensile stress, and/or bond wire slip clamp (23) when a "ball" is previously or simultaneously formed at the free end of the bond wire (10);
b) "touch-down" during ultrasonic excitation of the capillary (22) and opening of the bond wire clamp (28) shortly prior to "touch-down" and forming a first bond (25);
c) raising the bond head (21) to a preset loop level, preferably while opening the bond wire slip clamp (23) and if necessary switching off or switching over the coaxial flow of fluid;
d) positioning a second bond position (29) opposite the capillary (22), lowering the bond head (21) while pulling along the bond wire (10) against the effect of the coaxial flow of fluid, which can be reactivated if necessary, and the closed bond wire slip clamp (23), which can be re-closed if necessary, to a second "touch-down" and formation of a second bond (29) under ultrasonic effect; and
e) raising the bond head (21) to a so-called "tail-length" level when the bond wire clamp (28) is open, preferably when the bond wire slip clamp (23) is also open, and preferably when the coaxial flow is still effective, repeated closing of the bond wire clamp (28) and further raising of the bond head (21) while tearing off the bond wire (10) back into the initial position.

14. A process according to claim 13, characterised in that shortly prior to the respective second "touch-down" from the loop level, a bond wire clamp (24) fixedly disposed above the bond head (21) is closed while fixing the bond wire (10) or the corresponding return of the bond wire (10) through the capillary (22), which is moved downwards, preferably when the bond head (21) or the capillary (22) is at the preprogrammed intermediate level, in order to be reopened after the formation of the respective second bond (29).

## Revendications

1. Dispositif pour commander l'alimentation d'un fil de jonction, en particulier d'un fil de jonction en or (10), au "coin" que présente une pièce en coin ou au capillaire (22) d'une tête de jonction (21) déplaçable de haut en bas (double flèche 30), par un canal d'alimentation de fil de jonction (12, 18, 19, 20) placé avant le "coin" ou le capillaire (22), un raccord de fluide (15) débouchant dans le canal d'alimentation de fil de jonction (12, 18, 19, 20),
caractérisé en ce que le raccord de fluide (15) débouchant dans le canal d'alimentation de fil de jonction (12, 18, 19, 20) placé avant le "coin" ou le capillaire (22) pour l'alimentation du fil de jonction est relié au choix aussi bien à une source de gaz comprimé, en particulier une source d'air comprimé (13), qu'à une source de dépression (14).

2. Dispositif selon la revendication 1, caractérisé en ce qu'au raccord de fluide (15) est associée une soupape d'inversion (16) couplée à la commande de la tête de jonction, au moyen de laquelle le raccord de fluide (15) est relié soit à la source de gaz comprimé ou d'air comprimé (13), soit à la source de dépression (14).

3. Dispositif selon la revendication 1 ou 2, caractérisé en ce que le canal d'alimentation de fil de jonction présente une buse d'alimentation de fil (19), à laquelle se raccorde, du côté du coin ou du capillaire, un petit tube de guidage de fil (20) de plus grand diamètre intérieur, le raccord de fluide (15) relié à la source de gaz comprimé ou d'air comprimé (13) ou à la source de dépression (14) se trouvant directement après la buse d'alimentation de fil (19).

4. Dispositif selon la revendication 3, caractérisé en ce que la buse d'alimentation de fil (19) est fixée à l'extrémité, située du côté de l'alimentation, d'un alésage de passage (18) réalisé dans un bloc de montage (17), tandis que le petit tube de guidage de fil (20) est relié à l'extrémité située du côté coin ou du capillaire de l'alésage de passage (18), et en ce que le raccord de fluide (15) relié à la source de gaz comprimé ou d'air comprimé (13) ou à la source de dépression (14) débouche dans l'alésage de passage (18) entre la buse d'alimentation de fil (19) et le petit tube de guidage de fil (20).

5. Dispositif selon l'une des revendications 1 à 4, caractérisé en ce que le raccord de fluide (15) relié à la source de gaz comprimé ou d'air comprimé (13) ou à la source de dépression (14) débouche dans l'alimentation de fil de jonction (12) en formant un angle aigu avec la buse d'alimentation de fil (19).

6. Dispositif selon l'une des revendications 3 à 5, caractérisé en ce que le diamètre intérieur de l'étranglement situé du côté sortie de la buse de guidage de fil (19) atteint environ 100 à 130 µ pour un diamètre de fil inférieur à 100 µ, tandis que le petit tube de guidage de fil (20) suivant la buse de guidage de fil (19) présente un diamètre intérieur d'environ 1,5 à 2,2 mm.

7. Dispositif selon l'une ou plusieurs des revendications 1 à 6, caractérisé par une pince de glissement du fil de jonction (23) associée au canal d'alimentation de fil de jonction (12, 18, 19, 20), en particulier avant ou à l'extrémité côté capillaire de celui-ci, laquelle est activée ou fermée soit en permanence, soit seulement lors de l'abaissement de la tête de jonction (21) vers le "touch down" (contact).

8. Dispositif selon la revendication 7, caractérisé en ce que la pince de glissement du fil de jonction (23) est formée d'une pince dont les surfaces actives de serrage sont revêtues de feutre ou analogue.

9. Dispositif selon l'une des revendications 1 à 8, caractérisé en ce qu'après le canal de guidage de fil de jonction (12, 18, 19, 20) est prévue une pince fixe (24) pour le fil de jonction qui, après abaissement de la tête de jonction (21), peut avancer à partir d'une hauteur de boucle donnée sur une hauteur intermédiaire pendant le retour et l'éloignement correspondant d'un tronçon de fil de jonction (27) sortant vers le bas de la pointe du capillaire (26) directement avant le "touch down" suivant.

10. Procédé pour commander l'alimentation d'un fil de jonction, en particulier d'un fil de jonction en or (10), au "coin" (pièce en coin) ou au capillaire (22) d'une tête de jonction (21) déplaçable de haut en bas (double flèche 30) par l'intermédiaire d'un canal d'alimentation de fil de jonction (12, 18, 19, 20) placé avant le "coin" ou le capillaire (22), un raccord de fluide (15) débouchant dans le canal d'alimentation de fil de jonction (12, 18, 19, 20),
caractérisé en ce que le fil de jonction (10) est déplacé en direction du "coin" ou du capillaire (22) de la tête de jonction (21) pendant l'opération de jonction, en particulier lors de la formation de la boucle, au moyen d'un flux de gaz coaxial, en particulier d'un flux d'air, introduit par le raccord de fluide (15), ou qu'une traction est exercée dans la direction du "coin" ou du capillaire (22) de la tête de jonction (21) avec maintien d'une tension de fil sensiblement constante.

11. Procédé selon la revendication 10, caractérisé en ce que la direction du flux de gaz coaxial, en particulier du flux d'air, peut être inversée pendant l'opération de jonction et que l'intensité (pression et/ou allure) du flux de gaz, en particulier du flux d'air, est variable.

12. Procédé selon la revendication 10 ou 11, caractérisé en ce que le flux de gaz ou d'air coaxial comporte une composante de torsion autour du fil de jonction (10).

13. Procédé selon l'une des revendications 10 à 12, caractérisé par les étapes de procédé suivantes :
a) abaissement de la tête de jonction (21) à partir d'une position de démarrage ou de départ avec entraînement du fil de jonction (10) au moyen d'un dispositif de serrage (pince de fil de jonction (28)) prévu sur la tête de jonction (21) et déplaçable avec elle, l'entraînement du fil de jonction (10) se déroulant à l'encontre d'un flux de fluide coaxial et/ou d'une pince de glissement de fil de jonction (23) maintenant celui-ci avec une faible tension de serrage, avec formation préalable ou simultanée d'une "balle" à l'extrémité libre du fil de jonction (10);
b) "touch down" (contact) avec réglage aux ultrasons du capillaire (22) et ouverture de la pince de fil de jonction (28) peu avant le "touch down" et formation d'une première jonction (25);
c) soulèvement de la tête de jonction (21) jusqu'à une hauteur de bande prédéterminée, de préférence avec ouverture de la pince de glissement de fil de jonction (23) et éventuellement avec interruption ou inversion du flux du fluide coaxial;
d) positionnement d'un deuxième site de jonction (29) en face du capillaire (22), abaissement de la tête de jonction (21) avec entraînement du fil de jonction (10) à l'encontre de l'action du fluide coaxial éventuellement de nouveau activé et de la pince de glissement de fil de jonction (23) éventuellement fermée à nouveau, jusqu'à un deuxième "touch down" et réalisation d'une deuxième jonction (29) avec utilisation d'ultrasons; et
e) soulèvement de la tête de jonction (21) jusqu'à une hauteur dite de "tail-length", la pince de fil de jonction (28) étant ouverte et la pince de glissement de fil de jonction (23) étant de préférence également ouverte, mais le flux coaxial étant de préférence actif tout comme avant, fermeture répétée de la pince de fil de jonction (28) et à nouveau soulèvement de la tête de jonction (21) avec rupture du fil de jonction (10) pour revenir à la position de départ.

14. Procédé selon la revendication 13, caractérisé en ce que peu avant chaque deuxième "touch down" en partant de la hauteur de boucle, une pince à fil de jonction (24) montée fixe au-dessus de la tête de jonction (21) est fermée avec fixation du fil de jonction (10) ou retour correspondant du fil de jonction (10) par le capillaire (22) déplacé vers le bas, de préférence à une hauteur intermédiaire préprogrammée de la tête de jonction (21) ou du capillaire (22), pour être à nouveau fermée après réalisation de la deuxième jonction (29) correspondante.
